# EUROPEAN PATENT APPLICATION

(11) **EP 4 306 978 A1**
(43) Date of publication of application: **17.01.2024**
(21) Application number: 23771750.9
(22) Date of filing: 08.02.2023
(51) Int. Cl.: G01R 31/367, G01R 31/3842, H01M 50/579, H02M 3/04

(54) **BATTERY DEVICE AND BATTERY SYSTEM COMPRISING SAME**

(30) Priority: 25.05.2022 KR 20220064151
(71) Applicant: LG ENERGY SOLUTION, LTD., Seoul 07335 (KR)
(72) Inventor: CHOI, Jang Hyeok, Daejeon 34122 (KR); KIM, Tae Youn, Daejeon 34122 (KR); KIM, Minwoo, Daejeon 34122 (KR); KIM, Kyeongmin, Daejeon 34122 (KR)
(74) Representative: Goddar, Heinz J.
(86) International application number: PCT/KR2023/001861
(87) International publication number: WO 2023/229149

(57) **Abstract**

A battery device includes a battery pack including: a plurality of battery cells; a battery disconnect unit (BDU) including high voltage operation elements connected to the battery pack and monitoring a current of a battery pack current flowing in the battery pack; and a battery pack control module (BPCM) diagnosing a state of the battery pack based on battery state information indicating the state of the battery pack and transmitting necessary control instructions to the BDU based on the diagnosis result. The BDU includes: a current measuring unit that measures the battery pack current based on a result of detecting the battery pack current; a high voltage measuring unit that measures the battery pack voltage of the battery pack; an insulation resistance measuring unit that measures the insulation resistance of the battery pack; and a power DC-DC unit that generates a power voltage required for the operation of the BDU.

## Description

### [Technical Field]

### CROSS-REFERENCE TO RELATED APPLICATION

This application claims priority to and the benefit of Korean Patent Application No. 10-2022-0064151 filed in the Korean Intellectual Property Office on May 25, 2022, the entire contents of which are incorporated herein by reference.

The present disclosure relates to a battery device and a battery system including the same.

### [Background Art]

A hybrid electric vehicle (HEV), a plug-in hybrid electric vehicle (PHEV), and an electric vehicle driven by a motor require a high voltage battery. For the stability of the high voltage battery, a diagnosis circuit that diagnoses abnormalities as well as monitoring a voltage, a current, insulation resistance, a temperature, etc. of a plurality of battery packs constituting the high voltage battery is required.

The battery management system is a component that performs the monitoring, the diagnosis, etc., and may manage a plurality of battery packs provided in the vehicle. As the number of battery packs constituting the high voltage battery increases, the length of a wire harness connecting a plurality of battery packs and the battery management system increases, and the circuit that performs the monitoring and the diagnosis for each plurality of battery packs gets more complicated. This makes the design of the high voltage battery difficult.

### [Disclosure]

### [Technical Problem]

A battery device that improves a circuit complexity and a battery system that includes the same are provided.

### [Technical Solution]

In one feature of the invention, a battery device includes: a battery pack including a plurality of battery cells; a battery disconnect unit (BDU) including high voltage operation elements connected to the battery pack and monitoring a current of a battery pack flowing in the battery pack; and a battery pack control module (BPCM) diagnosing a state of the battery pack based on battery state information indicating the state of the battery pack and transmitting necessary control instructions to the BDU based on the diagnosis result. The BDU may include: a current measuring unit that measures the battery pack current based on a result of detecting the battery pack current; a high voltage measuring unit that measures the battery pack voltage of the battery pack; an insulation resistance measuring unit that measures the insulation resistance of the battery pack; and a power DC-DC unit that generates a power voltage required for the operation of the BDU.

The BDU may further include a shunt-type current sensor to detect the battery pack current.

The BUD may further include a Hall-type current sensor to detect the battery pack current, and the BPCM may include a current measuring unit that measures the battery pack current based on the result detected from the Hall-type current sensor.

The BDU may further include: a main positive contactor and a main negative electrode contactor connected to each of the positive electrode and the negative electrode of the battery pack; and a contactor controller that controls the operation of the main positive contactor and the main negative electrode contactor.

The BDU may further include: a pyro fuse that blocks the connection between the battery pack and the load due to an impact; and a pyro fuse controller to control the pyro fuse.

The BPCM may include a power DC-DC unit that supplies power in an insulated form to the power DC-DC unit of the BDU.

A battery system includes: a main battery device including a main battery pack; and a sub-battery device that includes a sub-battery pack connected to the main battery pack. The main battery device may include: a first battery disconnect unit (BDU) that includes high voltage operating elements connected to the main battery pack and monitors the current of the battery pack flowing to the main battery pack; and a battery pack control module (BPCM) that diagnoses the state of the main battery pack based on battery state information indicating the state of the main battery pack and transmits necessary control instructions to the BDU based on the diagnosis result. The first BDU may include: a current measuring unit that measures the battery pack current based on a result of detecting the battery pack current; a first high voltage measuring unit that measures the battery pack voltage of the main battery pack; a first insulation resistance measuring unit that measures the insulation resistance of the main battery pack; and a first power DC-DC unit that generates the power voltage required for the operation of the BDU.

The BPCM may further include a power DC-DC unit that supplies power in an insulated form to the first power DC-DC unit.

The sub-battery device may include a second BDU including high voltage operating elements connected to the sub-battery pack. The second BDU may include: a second high voltage measuring unit that measures the battery pack voltage of the sub-battery pack; a second insulation resistance measuring unit that measures the insulation resistance of the sub-battery pack; and a second power DC-DC unit that generates a power voltage required for operation of the BDU, and the BPCM may include a power DC-DC unit that supplies power in an insulated form to the second power DC-DC unit.

The first BDU may further include: a main positive contactor and a main negative electrode contactor connected to each of the positive electrode and the negative electrode of the main battery pack; and a contactor controller that controls the operation of the main positive contactor and the main negative electrode contactor.

Insulated power may be transferred from the BPCM to the first power DC-DC unit, and the first power DC-DC unit may supply a power voltage to the insulation measuring unit, the first high voltage measuring unit, the first insulation resistance measuring unit, and the contactor controller as the insulated power.

A power may be transferred from the BPCM to the first power DC-DC unit, and the first power DC-DC unit may include a DC-DC converter that converts the transferred power and a transformer connected to the output of the DC-DC converter. A power voltage may be supplied from the transformer to the insulation measuring unit, the first high voltage measuring unit, the first insulation resistance measuring unit, and the contactor controller.

The first BDU may further include: a pyro fuse that blocks the connection between the main battery pack and the load due to an impact; and a pyro fuse controller to control the pyro fuse. Insulated power may be transferred from the BPCM to the first power DC-DC unit, and the first power DC-DC unit may supply a power voltage to the insulation measuring unit, the first high voltage measuring unit, the first insulation resistance measuring unit, and the pyro fuse controller.

Power may be transferred from the BPCM to the first power DC-DC unit, and the first power DC-DC unit may include a DC-DC converter that converts the transferred power and a transformer connected to the output of the DC-DC converter, and a power voltage may be supplied to the insulation measuring unit, the first high voltage measuring unit, the first insulation resistance measuring unit, and the pyro fuse controller from the transformer.

### [Advantageous Effects]

The present invention provides a battery device with improved circuit complexity and a battery system including the same.

### [Description of the Drawings]

FIG. 1 is a block diagram showing a battery device to explain the present invention.
FIG. 2 is a view showing a battery device according to an embodiment.
FIG. 3 is a view showing a battery device according to an embodiment.
FIG. 4 is a view showing a battery device according to an embodiment.
FIG. 5 is a view showing a battery device according to an embodiment.
FIG. 6 is a view showing a battery system according to an embodiment.
FIG. 7 is a view showing a battery system according to an embodiment.
FIG. 8 is a block diagram showing power transfer between a BPCM and a BDU according to an embodiment.
FIG. 9 is a view showing some configurations of a battery system according to an embodiment.
FIG. 10 is a block diagram showing power transfer between a BPCM and a BDU according to an embodiment.

### [Mode for Invention]

Embodiments disclosed in the present specification will be described in detail with reference to the accompanying drawings. In the present specification, the same or similar components will be denoted by the same or similar reference numerals, and an overlapped description thereof will be omitted. The terms "module" and "unit" for components used in the following description are used only in order to make the specification easier. Therefore, these terms do not have meanings or roles that distinguish them from each other by themselves. In describing embodiments of the present specification, when it is determined that a detailed description of the well-known art associated with the present invention may obscure the gist of the present invention, it will be omitted. The accompanying drawings are provided only in order to allow embodiments disclosed in the present specification to be easily understood and are not to be interpreted as limiting the spirit disclosed in the present specification, and it is to be understood that the present invention includes all modifications, equivalents, and substitutions without departing from the scope and spirit of the present invention.

Terms including ordinal numbers such as first, second, and the like will be used only to describe various components, and are not interpreted as limiting these components. The terms are only used to differentiate one component from others.

It will be further understood that terms "comprises" or "have" used in the present specification specify the presence of stated features, numerals, steps, operations, components, parts, or a combination thereof, but do not preclude the presence or addition of one or more other features, numerals, steps, operations, components, parts, or a combination thereof.

A program implemented as a set of instructions embodying a control algorithm necessary to control another configuration may be installed in a configuration for controlling another configuration under a specific control condition among configurations according to an embodiment. The control configuration may process input data and stored data, based on the installed program to generate output data. The control configuration may include a nonvolatile memory storing the program and a memory storing the data.

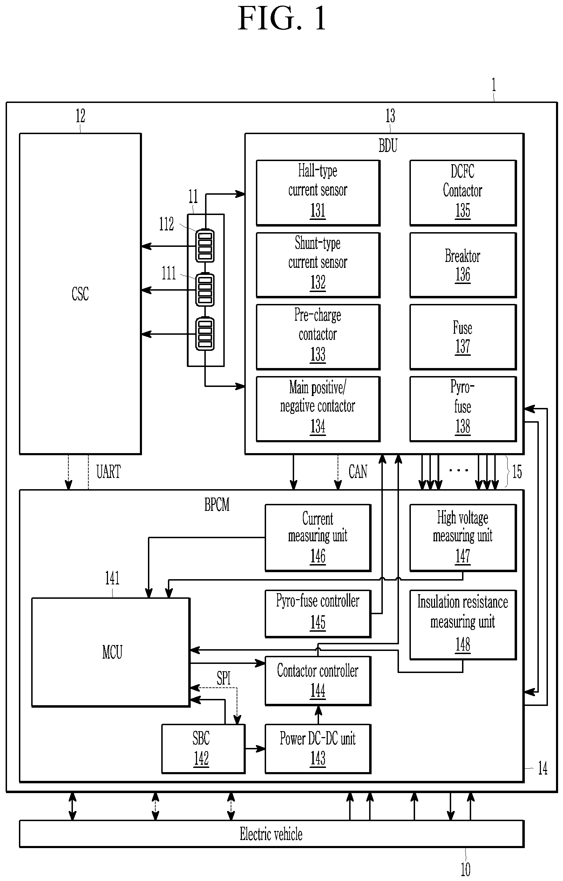

FIG. 1 is a block diagram showing a battery device to explain the present invention.

As shown in FIG. 1, a battery device 1 may include a battery pack 11, a cell supervisory circuit (CSC) 12, a battery disconnect unit (BDU) 13, and a battery pack control module (BPCM) 14. The battery device 1 is electrically connected to an electric vehicle (Electric Vehicle) 10 to supply power to the electric vehicle 10, and is connected to the electric vehicle 10 through CAN communication, wireless communication, etc. to transmit and receive information related to the power supply. In addition, the battery device 1 may be charged through the power supplied from the electric vehicle 10, and may transmit and receive the information necessary for the charge control with the electric vehicle 10.

In FIG. 1, the battery pack 11 is shown to include three battery modules composed of four battery cells, but the invention is not limited thereto. Three battery modules 111 are connected in series, and the battery module 111 may include four battery cells 112 connected in series.

The CSC 12 may monitor a plurality of cell voltages of a plurality of battery cells constituting the battery pack 11 and temperatures of a plurality of battery cells and perform cell balancing. The CSC 12 may transmit the information obtained by the CSC 12 to the BPCM 14 through communication with the BPCM 14, and receive a control instruction related to the monitoring and the cell balancing from the BPCM 14. The CSC 12 may be connected to both terminals of each of a plurality of battery cells 112.

The BDU 13 includes high voltage operating elements connected to the battery pack 11 and may monitor the current of the battery pack current flowing in the battery pack 11. For example, the BDU 13 may include a Hall-type current sensor 131, a shunt-type current sensor 132, a pre-charge contactor 133, a main positive/negative electrode contactor 134, a direct current fast charging (DCFC) contactor 135, a Breaktor 136, a fuse 137, and a pyro fuse 138. The pre-charge contactor 133, the main positive/negative contactor 134, a direct current fast charging (DCFC) contactor 135, the Breaktor 136, the fuse 137, and the pyro fuse 138 may be high voltage operating elements that are directly connected to a positive electrode or a negative electrode of the battery pack 11, a battery module constituting the battery pack 11, etc., and a high voltage may be applied to both terminals thereof.

Two current sensors 131 and 132 may respectively generate a detection signal by detecting the battery pack current flowing in the battery pack 11. The Hall-type current sensor 131 measures the battery pack current by using a Hall sensor electromagnetically coupled to wiring in which the battery pack current flows, and the shunt-type current sensor 132 may measure the battery pack current by using a shunt resistor positioned on a path through which the battery pack current flows.

The pre-charge contactor 133 may be connected between the positive electrode of the battery pack 11 and the positive output terminal of the battery device 1, and the main positive/negative contactor 134 may include a main positive contactor connected between the positive electrode of the battery pack 11 and the positive output terminal and a main negative contactor connected between the negative electrode of the battery pack 11 and the negative output terminal.

The DC fast charging contactor 135 may be connected to an external charger to quickly charge the battery pack 11.

The Breaktor 136 is a protective circuit to protect the battery device 1 from an overcurrent and an overvoltage.

The fuse 137 may protect the battery pack 11 from the overcurrent, and the pyro fuse 138 may cut off the connection between the battery pack 11 and the load due to an impact. The load may be the electric vehicle 10 shown in FIG. 1.

Each component of the BDU 13 may be implemented with known technology, so detailed descriptions are omitted in this specification.

The BPCM 14 may generate control instructions necessary for the CSC 12 and the BDU 13 based on the information received from the CSC 12 and the BDU 13 to be transmitted to the CSC 12 and the BDU 13. The BPCM 14 may diagnose the state of the battery cell and the battery pack 11 based on state information representing the state of the battery cell and the battery pack 11, such as the cell voltage of the battery cell, the temperature, the voltage, the current, and the temperature of the battery pack 11, and transmit the necessary control instructions to the CSC 12 and the BDU 13 based on the diagnosis result. The BPCM 14 may receive information necessary for managing the battery pack 11 through communication with the electric vehicle 10 and transmit necessary control instructions to the CSC 12 and the BDU 13 based on the received information.

The BPCM 14 may include a main control unit (MCU) 141, a system basis chip (SBC) 142, a power DC-DC unit 143, a contactor controller 144, a pyro fuse controller 145, a current measuring unit 146, a high voltage measuring unit 147, and an insulation resistance measuring unit 148. In addition to the configurations shown in FIG. 1, various configurations such as a communication bridge IC, a temperature measuring unit, an EEPROM, and a CAN communication unit may be provided in the BPCM 14.

The MCU 141 may analyze the battery state information for the battery pack 11 to determine the state of the battery pack 11, and control necessary management operations according to the determined state. For example, the MCU 141 may perform the cell balancing by controlling the CSC 12 when there is a battery cell requiring the cell balancing among the battery pack 11. The MCU 141 may estimate the SOC of the battery pack 11 by integrating the battery pack current, and control the charge and discharge based on the estimated SOC. The SOH of battery pack 11 may be estimated based on the internal resistance of the battery pack 11. The MCU 141 may determine whether a protection operation for the battery pack 11 is required based on the battery state information, and may activate the protection operation if the protection operation is required.

The SBC 142 may manage the power in the battery device 1 under the control of the MCU 141. The SBC 142 may provide multiple output power sources by generating power sources of different levels, may be implemented as an integrated circuit, may transmit and receive necessary information with other configurations through CAN or LIN communication, and may provide stable functions for the battery device 1. The SBC 142 may receive control instructions through the SPI communication with the MCU 141.

The power DC-DC unit 143 converts the voltage of the power supplied from the SBC 142 to generate a voltage required for the operation of the BPCM 14. The voltage generated by the power DC-DC unit 143 may be supplied to the components of the BPCM 14. For example, the contactor controller 144 may generate a control signal to control the opening and closing of the pre-charge contactor 133 and the main positive/negative contactor 134 of the BDU 13 by using the voltage supplied from the power DC-DC unit 143.

The contactor controller 144 may generate the control signals for controlling the pre-charge contactor 133 and the main positive/negative contactor 134 of the BDU 13 under the control of the MCU 141, and transmit them to the pre-charge contactor 133 and the main positive/negative contactor 134. The contactor controller 144 may receive a power voltage required to generate control signals from the power DC-DC unit 143.

The pyro fuse controller 144 may generate and transmit a control signal for controlling the pyro fuse 139 to the pyro fuse 139 under the control of the MCU 141. The contactor controller 144 may receive a power voltage required to generate the control signals from the power DC-DC unit 143.

The current measuring unit 146 may receive the detection signals measured from two current sensors 131 and 132 of the BDU 13 and measure the battery pack current flowing in the battery pack 11. The current measuring unit 146 may transmit information indicating the measured battery pack current to the MCU 141.

The high voltage measuring unit 147 is connected to the battery pack 11 through the high voltage cable 15, and may measure the battery pack voltage of the battery pack 11.

In addition, the high voltage measuring unit 147 may measure the voltages of the nodes having a high voltage, such as both terminal voltages of each of the main positive/negative contactor 135, both terminal voltages of the pyro fuse 139, and both terminal voltages of the fuse 137 through the high voltage cable 15. The high voltages measured by the high voltage measuring unit 147 are transmitted to the MCU 141, and based on the measured high voltages, the MCU 141 may perform the diagnose for the closing/opening (stuck closing/opening) for the main positive/negative contactor 135, the fuse 137, the pyro fuse 139, etc.

The insulation resistance measuring unit 148 may measure the insulation resistance of the battery pack 11. The insulation resistance measuring unit 148 may be connected to the battery pack 11 through the high voltage cable 15 to measure the insulation resistance. The insulation resistance measuring unit 148 may transmit the measured insulation resistance value to the MCU 141. The MCU 141 may determine whether there is a leakage problem of the battery pack 11 based on the received insulation resistance value. For example, if the measured insulation resistance is less than a predetermined threshold value, the MCU 141 may determine that there is a problem in the insulation and leakage current flows.

The high voltage cable 15 may have a first terminal connected to a plurality of nodes for measuring the voltages of the positive electrode and the negative electrode of the battery pack 11, the positive electrode and the negative electrode of each of a plurality of battery modules 111 configuring the battery pack 11, both terminals of the fuse 137, both terminals of the pyro fuse 139, both terminals of each of the main positive/negative contactors 135, etc. The second terminal of the high voltage cable 15 may be connected to a component, for example, the high voltage measuring unit 147, the insulation resistance measuring unit 148, etc. to measure a high voltage.

Since the high voltage cable 15 is connected into the battery pack 11 and the BDU 13 and extended to the BPCM 14, the length of the high voltage cable 15 is long, thereby increasing the design complexity of the battery device 1. That is, since the nodes to be measured through the high voltage cable 15 must enter the BPCM 14 and be connected to the BPCM 14, the length of the high voltage cable 15 increases as the distance between the BPCM 14 and the node increases. Such design complexity may also increase a safety risk due to the high voltage.

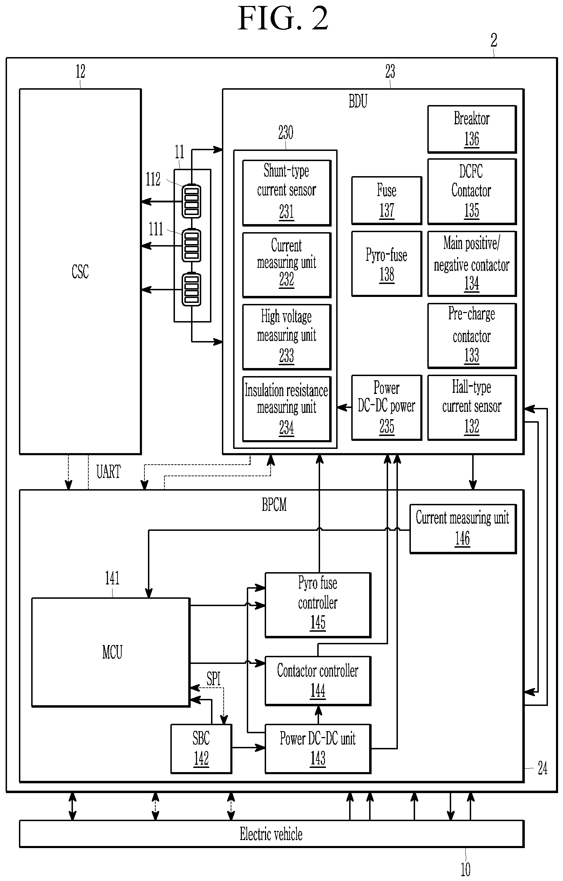

FIG. 2 is a view showing a battery device according to an embodiment.

In the battery device 2 shown in FIG. 2, compared with the battery device 1 shown in FIG. 1, the same configurations are indicated by the same reference numerals as the reference numerals described in FIG. 1. As shown in FIG. 2, the battery device 2 includes a battery pack 11, a CSC 12, a BDU 23, and a BPCM 24, and the BDU 23 includes a high voltage monitoring IC 230 and a power DC-DC unit 235. Although not shown in FIG. 2, the BDU 23 may include, like the BDU 13 of FIG. 1, the Hall-type current sensor 131, the pre-charge contactor 133, the main positive/negative contactor 134, the DC fast charging (DCFC) contactor 135, the Breaktor 136, the fuse 137, and the pyro fuse 138.

The high voltage monitoring IC 230 include a shunt-type current sensor 231, a current measuring unit 232, a high voltage measuring unit 233, and an insulation resistance measuring unit 234. The shunt-type current sensor 231, the high voltage measuring unit 233 and the insulation resistance measuring unit 234 of the BDU 23 may be the configurations performing the same functions of the shunt-type current sensor 131, the high voltage measuring unit 147, and the insulation resistance measuring unit 148 of the battery device 1. As such, the configurations related to high voltage may be bundled and implemented as the high voltage monitoring IC 230.

The current measuring unit 232 may measure the battery pack current based on the signal received from the shunt-type current sensor 231. The current measuring unit 232 may transmit the information about the measured battery pack current to the BPCM 24 through the CAN communication.

The high voltage measuring unit 233 may be connected to the battery pack 11 and measure the battery pack voltage of the battery pack 11. In addition, the high voltage measuring unit 233 may measure the voltages of the nodes having high voltages, such as both terminal voltages of each of the main positive/negative contactor 135, both terminal voltages of the pyro fuse 139, and both terminal voltages of the fuse 137. The high voltages measured by the high voltage measuring unit 233 may be transmitted to the MCU 141, and the MCU 141 may perform the diagnosis for the stuck closing/opening regarding the main positive/negative contactor 135, the fuse 137, the pyro fuse 139, and the like based on the measured high voltages.

The insulation resistance measuring unit 234 may determine whether there is a leakage problem of the battery pack 11 by measuring the insulation resistance of the battery pack 11. The insulation resistance measuring unit 234 may be connected to the battery pack 11 to measure the insulation resistance.

The power DC-DC unit 235 may generate the power voltage required for operation of the BDU 23. The power DC-DC unit 235 may receive the voltage generated by the power DC-DC unit 143 of the BPCM 24 and generate the voltage required for the BDU 23.

As such, the high voltage cable may not be extended into the BPCM 24 by positioning the related components that receive and process the high voltages within the BDU 23. Through this, the design complexity of the battery device 2 may be reduced compared to that of FIG. 1.

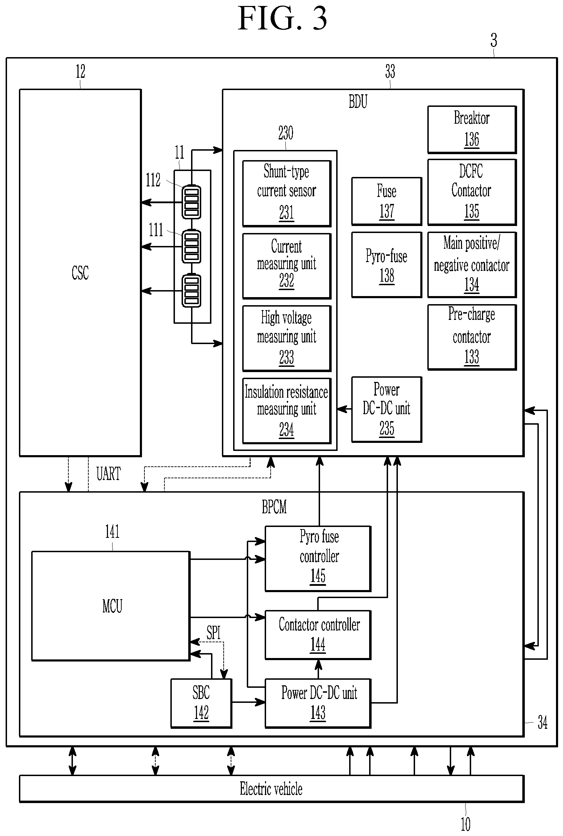

FIG. 3 is a view showing a battery device according to an embodiment.

In the battery device 3 shown in FIG. 3, compared with the battery devices 1 and 2 shown in FIG. 1 and FIG. 2, the same configurations are indicated by the same reference numerals as the reference numerals described in FIG. 1 and FIG. 2. As shown in FIG. 3, the battery device 3 includes a CSC 12, a BDU 33, and a BPCM 34, and the BDU 33 does not include the Hall-type current sensor 131, unlike the BDU 23. Correspondingly, since the BPCM 34 does not receive the information about the battery pack current, it does not include the current measuring unit 146 either.

Unlike the battery device 1 using two types of the current sensors 131 and 132, the battery device 3 includes only one shunt-type current sensor 231. Through this, it is possible to reduce the production cost of the battery device and secure the space within the battery device.

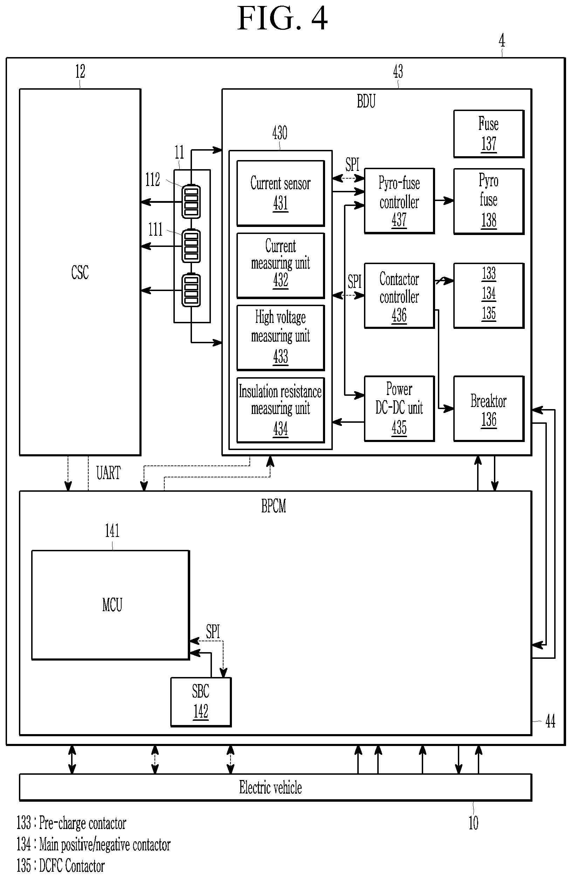

FIG. 4 is a view showing a battery device according to an embodiment.

In the battery device 4 shown in FIG. 4, compared with the battery devices 1, 2, and 3 shown in FIG. 1 to FIG. 3, the same configurations are indicated by the same reference numerals as the reference numerals described in FIG. 1 to FIG. 3. As shown in FIG. 4, the battery device 4 includes a CSC 12, a BDU 43, and a BPCM 44, and the BDU 43 includes a high voltage monitoring IC 430, a power DC-DC unit 435, a contactor controller 436, and a pyro fuse controller 437. The BDU 43, like the BDU 13 of FIG. 1, may further include the pre-charge contactor 133, the main positive/negative contactor 134, the DC fast charging (DCFC) contactor 135, the Breaktor 136, the fuse 137, and the pyro fuse 138.

The high voltage monitoring IC 430 may include both of the Hall-type and the shunt-type current sensor 431. Since components related to high voltage and current are integrated in the high voltage monitoring IC 430, it is possible to implement both types of current sensors. However, the invention is not limited thereto, and the high voltage monitoring IC 430 may include only one type of current sensor.

The current measuring unit 432 may measure the battery pack current based on the signal received from the Hall-type and the shunt-type current sensor 431. The current measuring unit 432 may transmit the information about the measured battery pack current to the BPCM 44 through the CAN communication.

The power DC-DC unit 435 may generate the power voltage of the BDU 43 by converting the power supplied from the outside of the BDU 43. For example, the power DC-DC unit 435 converts the power supplied from the battery pack 11 to generate the power voltage required for the BDU 43.

The contactor controller 436 may operate with the voltage supplied from the power DC-DC unit 435, transmit and receive the information with the high voltage monitoring IC 430 through the SPI communication, and obtain the necessary information to control the operation of the contactors 133, 134, and 135 and the Breaktor 136. The contact controller 436 may control the operations of the contactors 133, 134, and 135 and the Breaktor 136 based on the control instruction from the MCU 141 and the information received from the high voltage monitoring IC 430.

The pyro fuse controller 437 may operate with the voltage supplied from the power DC-DC unit 435, and transmit and receive the information with the high voltage monitoring IC 430 through the SPI communication to obtain the information required to control the pyro fuse 138. The pyro fuse controller 437 may control the pyro fuse 138 based on information received from the high voltage monitoring IC 430. If necessary, the pyro fuse controller 437 may receive the control instruction from the MCU 141 and consider the control instruction from the MCU 141 in controlling the pyro fuse 138.

The BPCM 44 does not include the power DC-DC unit compared to the embodiment shown in FIG. 3. Since the BDU 43 includes the power DC-DC unit 435 that provides the voltage required for the operation, the BPCM 44 may not include the power DC-DC unit for supplying the power to the outside.

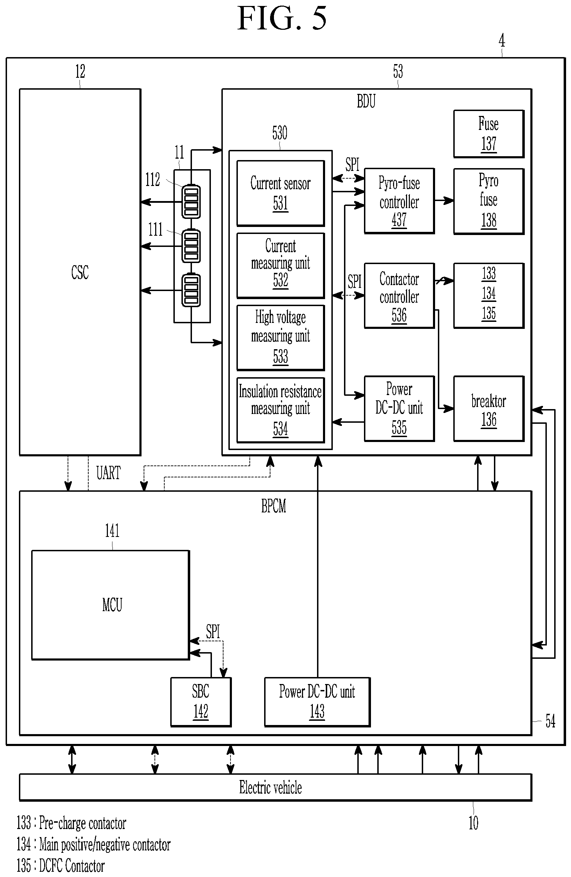

FIG. 5 is a view showing a battery device according to an embodiment.

Between the battery device 5 shown in FIG. 5 and the battery device 4 shown in FIG. 4, there is a difference only in the power generation configurations. For example, the BDU 43 of the battery device 4 receives the power from the battery pack 11 to generate the power voltage of BDU 43, and the BDU 53 of the battery device 5 receives the power from the power DC-DC unit 143 of the BPCM 54. The BDU 53 includes the power DC-DC unit 535, and the power DC-DC unit 535 converts the power supplied from the power DC-DC unit 143 of the BPCM 54 to generate the power voltage of the BDU 53.

The BDU 53, like the BDU 13 of FIG. 1, may include the pre-charge contactor 133, the main positive/negative contactor 134, the DC fast charging (DCFC) contactor 135, the Breaktor 136, the fuse 137, and the pyro fuse 138. The components 531 to 534 of the high voltage monitoring IC 530 of the BDU 53, the contact control unit 536, and the pyro fuse control unit 537 are the same as the components 431 to the 434 of the high voltage monitoring IC 430 of the BDU 43, the contact controller 436, and the pyro fuse controller 437.

In the embodiments so far, the battery device has been described as including one battery pack, but the invention is not limited thereto. In the following embodiments, the battery device will be described as including a plurality of battery packs. Compared to the embodiments described above, the description of the same configurations is omitted.

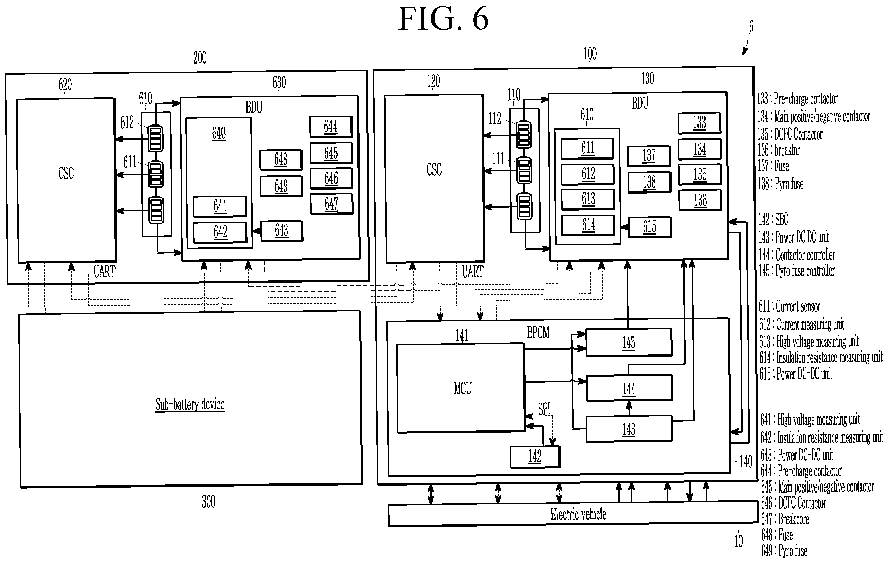

FIG. 6 is a view showing a battery system according to an embodiment.

In FIG. 6, the battery system 6 is shown as including three battery devices 100, 200, and 300. The number of the battery packs is not limited to that shown in FIG. 6.

The main battery device 100, which is one of three battery devices 100, 200, and 300, may be implemented as one of the battery devices 2 to 5 shown in FIG. 2 to FIG. 5. For the main battery device 100 shown in FIG. 6, compared to the battery device 3 shown in FIG. 3, the constituent elements and operations thereof may be similar.

The main battery device 100 includes the battery pack 110, the CSC 120, the BDU 130, and the BPCM 140. The descriptions overlapping those of the battery pack 11, the CSC 12, the BDU 33, and the BPCM 34 of the battery device 3 shown in FIG. 3 will be omitted.

The BDU 130 may include a high voltage monitoring IC 610, a power DC-DC unit 615, the pre-charge contactor 133, the main positive/negative contactor 134, the DC fast charging (DCFC) contactor 135, the Breaktor 136, the fuse 137, and the pyro fuse 138. The high voltage monitoring IC 610 may include a shunt-type current sensor 611, a current measuring unit 612, a high voltage measuring unit 613, and an insulation resistance measuring unit 614.

The high voltage measuring unit 613 may be connected to the battery pack 110 and measure the battery pack voltage of the battery pack 110. In addition, the high voltage measuring unit 613 may measure the voltages of the nodes having high voltages such as both terminal voltages of each of the main positive/negative contactor 134, both terminal voltages of the DCFC contactor 135, both terminal voltages of the pyro fuse 138, both terminal voltages of the fuse 137, and the like. The high voltages measured by the high voltage measuring unit 613 are transmitted to the MCU 141, and the MCU 141 may diagnose the stuck closing/opening for the main positive/negative contactor 134, the DCFC contactor 135, the fuse 137, and the pyro fuse 138 based on the measured high voltages.

The contactor controller 144 of the BPCM 140 may generate a control signal for controlling the operation of the pre-charge contactor 133, the main positive/negative contactor 134, the DCFC contactor 135, and the Breaktor 136 of the sub-battery device 200, and transmit it to the BDU 130. The pyro fuse controller 145 of the BPCM 140 may generate and transmit a control signal for controlling the operation of the pyro fuse 138 to the BDU 130.

The insulation resistance measuring unit 614 may determine whether there is a leakage problem of the battery pack 110 by measuring the insulation resistance of the battery pack 110. The insulation resistance measuring unit 614 may be connected to the battery pack 110 to measure the insulation resistance.

The power DC-DC unit 615 may generate a voltage necessary for the operation of the BDU 130. The power DC-DC unit 615 may receive the voltage generated by the power DC-DC unit 143 of the BPCM 140 to generate the voltage required for the BDU 130.

The BDU 130 of the main battery device 100 may transmit information about the battery pack current to the sub-battery devices 200 and 300 and the MCU 141 of the BPCM 140 through UART communication. Alternatively, the BDU 130 may transmit information about the battery pack current to the MCU 141 through UART communication, and the MCU 141 may transmit information about the battery pack current to the sub-battery devices 200 and 300. Since a plurality of battery devices 100, 200, and 300 are connected in series, the same battery pack current may flow. In the BDU 130 of the main battery device 100, the current measuring unit 612 may measure the battery pack current by using the signal received from the shunt-type current sensor 611. The BDU 130 may transmit the current measured by the current measuring unit 612 to the BDU 220 and/or the MCU 141 of each of the sub-battery devices 200 and 300 through the UART communication. Then, the configuration of the current sensor and the current measuring unit is not required for the sub-battery devices 200 and 300.

The BPCM 140 may include the MCU 141, the SBC 142, the power DC-DC unit 143, the contactor controller 144, and the pyro fuse controller 145. The MCU 141 may receive state information about the battery packs 110, 210, and 310 from each of a plurality of battery devices 100, 200, and 300 and generate a control instruction for controlling the operation of each battery device 100, 200, and 300 based on the state information. The control instructions may include cell balancing control of each battery device 100, 200, and 300, charge and discharge control of the battery pack, overvoltage protection operation control, and overcurrent protection operation control.

The power DC-DC unit 143 supplies power to the BDUs 130 and 630 of each of a plurality of battery devices 100, 200, and 300, the contactor controller 144 transmits contactor control signals to the BDU 130 of the battery device 100, and the pyro fuse controller 145 may transmit a pyro fuse control signal to the BDU 130 of the battery device 100.

The sub-battery device 200 may include a battery pack 610, a CSC 620, and a BDU 630. The description of the same configuration as that of the battery device 1 shown in FIG. 1 is omitted.

The BDU 630 may include a high voltage monitoring IC 640, a power DC-DC unit 643, a pre-charge contactor 644, a main positive/negative contactor 645, a DC fast charging (DCFC) contactor 646, a Breaktor 647, a fuse 648, and a pyro fuse 649. The high voltage monitoring IC 640 may include a high voltage measuring unit 641 and an insulation resistance measuring unit 642.

The high voltage measuring unit 641 may be connected to the battery pack 610 and measure the battery pack voltage of the battery pack 610. In addition, the high voltage measuring unit 641 may measure voltages of nodes having high voltages such as both terminal voltages of each of the main positive/negative contactor 645, both terminal voltages of the DCFC contactor 646, both terminal voltages of the pyro fuse 649, both terminal voltages of the fuse 648, and the like. The high voltages measured by the high voltage measuring unit 641 are transmitted to the MCU 141, and the MCU 141 may perform the diagnose for the stuck closing/opening for the main positive/negative contactor 636, the DCFC contactor 646, the fuse 648, the pyro fuse 649, etc. based on the measured high voltages,

The contactor controller 144 of the BPCM 140 may generate control signals for controlling the operation of the pre-charge contactor 644, the main positive/negative contactor 645, the DCFC contactor 646, and the Breaktor 647 of the sub-battery device 200, and transmit them to the sub-battery device 200. The pyro fuse controller 145 of the BPCM 140 may generate and transmit a control signal for controlling the operation of the pyro fuse 649 to the sub-battery device 200.

The insulation resistance measuring unit 642 may determine whether there is a leakage problem of the battery pack 610 by measuring the insulation resistance of the battery pack 610. The insulation resistance measuring unit 642 may be connected to the battery pack 610 to measure the insulation resistance.

The power DC-DC unit 643 may generate a voltage necessary for the operation of the BDU 630. The power DC-DC unit 643 may receive the voltage generated by the power DC-DC unit 143 of the BPCM 140 and generate the voltage required for the BDU 630.

In FIG. 6, the BDU 630 of the sub-battery device 200 is shown including the pre-charge contactor 644, the main positive/negative contactor 645, the DCFC contactor 646, the Breaktor 647, and the pyro fuse 649, but the present invention is not limited thereto. For example, the BDU 630 may include only a contactor and a fuse 648 for connecting the adjacent battery pack (for example, 110) and the battery pack 610. In this case, the BDU 630 may control a corresponding contactor by using only a control signal for one contactor among the control signals received from the pyro fuse controller 145 and the contactor controller 144.

Since the configuration of the sub-battery device 300 is the same as that of the sub-battery device 200, the detailed description thereof is omitted.

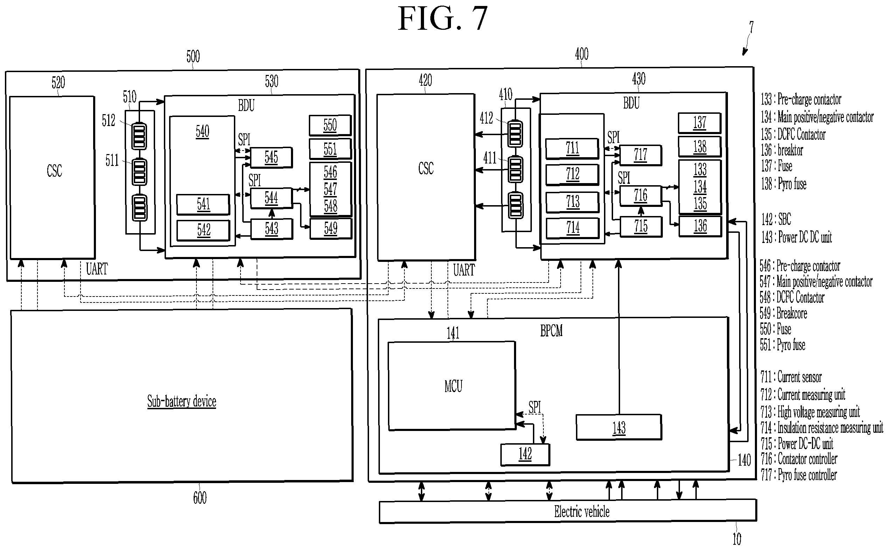

FIG. 7 is a view showing a battery system according to an embodiment.

In FIG. 7, the battery system 7 is shown as including three battery devices 400, 500, and 600. The number of the battery packs is not limited to that shown in FIG. 7.

The main battery device 400, which is one of three battery devices 400, 500, and 600, may be implemented as one of the battery devices 2 to 5 shown in FIG. 2 to FIG. 5. For the main battery device 400 shown in FIG. 7, compared to the battery device 5 shown in FIG. 5, the constituent elements and the operation may be similar.

The main battery device 400 includes a battery pack 410, a CSC 420, a BDU 430, and a BPCM 440. The descriptions overlapping those of the battery pack 11, the CSC 12, the BDU 53, and the BPCM 54 of the battery device 5 shown in FIG. 5 will be omitted.

The BDU 430 may include a high voltage monitoring IC 710, a power DC-DC unit 715, a contactor controller 716, a pyro fuse controller 717, a pre-charge contactor 133, a main positive/negative contactor 134, a DC fast charging (DCFC) contactor 135, a Breaktor 136, a fuse 137, and a pyro fuse 138. The high voltage monitoring IC 710 may include a shunt-type and Hall-type current sensor 711, a current measuring unit 712, a high voltage measuring unit 713, and an insulation resistance measuring unit 714.

The high voltage measuring unit 713 may be connected to the battery pack 410 and measure the battery pack voltage of the battery pack 410. In addition, the high voltage measuring unit 713 may measure voltages of nodes having high voltages such as both terminal voltages of each of the main positive/negative contactor 134, both terminal voltages of the DCFC contactor 135, both terminal voltages of the pyro fuse 138, both terminal voltages of the fuse 137, etc. The high voltages measured by the high voltage measuring unit 713 may be transmitted to the MCU 141, and the MCU 141 may perform the diagnosis of the stuck closing/opening for the main positive/negative contactor 134, the DCFC contactor 135, the fuse 137, and the pyro fuse 138, based on the measured high voltages.

The insulation resistance measuring unit 714 may determine whether there is a leakage problem of the battery pack 410 by measuring the insulation resistance of the battery pack 410. The insulation resistance measuring unit 714 may be connected to the battery pack 410 to measure the insulation resistance.

The power DC-DC unit 715 may generate a voltage necessary for the operation of the BDU 430. The power DC-DC unit 715 may receive the voltage generated by the power DC-DC unit 143 of the BPCM 140 and generate the voltage required for the BDU 730.

The BDU 430 of the main battery device 400 may transmit information about the battery pack current to the sub-battery device 500 and 600 and the MCU 141 of the BPCM 440 through the UART communication. Also, the BDU 430 may transmit information about the battery pack current to the MCU 141 through the UART communication, and the MCU 141 may transmit information about the battery pack current to the sub-battery devices 500 and 600. Since a plurality of battery devices 400, 500, and 600 are connected in series, the same battery pack current can flow. In the BDU 430 of the main battery device 400, the current measuring unit 712 may measure the battery pack current by using a signal received from the shunt-type and Hall-type current sensor 611. The BDU 430 may transmit the current measured by the current measuring unit 712 to the BDU 520 and/or the MCU 141 of each of the sub-battery devices 500 and 600 through the UART communication. Then, the configurations of the current sensor and the current measuring unit are not required for the sub-battery devices 500 and 600.

The BPCM 440 may include the MCU 141, the SBC 142, and the power DC-DC unit 143. The MCU 141 may receive state information about the battery pack 410 and 510 from each of a plurality of battery devices 400, 500, and 600, and may generate a control instruction for controlling the operation of each of the battery devices 400, 500, and 600 based on the state information. The control instructions may include cell balancing control of each battery device 400, 500, and 600, charge and discharge control of the battery pack, overvoltage protection operation control, and overcurrent protection operation control. The power DC-DC unit 143 may supply power to the BDUs 430 and 530 of each of a plurality of battery devices 400, 500, and 600.

The contactor controller 716 may operate with the voltage supplied from the power DC-DC unit 715, and may obtain information necessary for controlling the operation of the contactors 133, 134, and 135 and the Breaktor 136 by transmitting and receiving information with the high voltage monitoring IC 710 through the SPI communication. The contact controller 716 may control the operation of the contactors 133, 134, and 135 and the Breaktor 136 based on the control instruction from the MCU 141 and the information received from the high voltage monitoring IC 710.

The pyro fuse controller 717 may operate with the voltage supplied from the power DC-DC unit 715, and may obtain information required to control the pyro fuse 138 by transmitting and receiving information with the high voltage monitoring IC 710 through the SPI communication. The pyro fuse controller 717 may control the pyro fuse 138 based on the information received from the high voltage monitoring IC 710. If necessary, the pyro fuse controller 717 may receive a control instruction from the MCU 141 and consider the control instruction from the MCU 141 in controlling the pyro fuse 138.

The sub-battery device 500 may include the battery pack 510, the CSC 520, and the BDU 530. The description of the same configuration as that of the battery device 1 shown in FIG. 1 is omitted.

The BDU 530 may include the high voltage monitoring IC 540, the power DC-DC unit 543, the contactor controller 544, the pyro fuse controller 545, the pre-charge contactor 546, the main positive/negative contactor 547, the DCFC contactor 548, the Breaktor 549, the fuse 550, and the pyro fuse 551. The high voltage monitoring IC 540 may include a high voltage measuring unit 541 and an insulation resistance measuring unit 542.

The high voltage monitoring IC 540 may include the high voltage measuring unit 541 and the insulation resistance measuring unit 542.

The high voltage measuring unit 541 may be connected to the battery pack 510 and measure the battery pack voltage of the battery pack 510. In addition, the high voltage measuring unit 541 may measure voltages of nodes having a high voltage such as both terminal voltages of each of the main positive/negative contactor 547, both terminal voltages of the DCFC contactor 548, both terminal voltages of the pyro fuse 551, both terminal voltages of the fuse 550, etc. The high voltages measured by the high voltage measuring unit 541 may be transmitted to the MCU 141, and the MCU 141 may perform the diagnose about the stuck close/open for the main positive/negative contactor 547, the DCFC contactor 548, the fuse 550, and the pyro fuse 551 based on the measured high voltages.

The insulation resistance measuring unit 542 may determine whether there is a leakage problem in the battery pack 510 by measuring the insulation resistance of the battery pack 510. The insulation resistance measuring unit 542 may be connected to the battery pack 510 to measure the insulation resistance.

The power DC-DC unit 543 may generate the power voltage of the BDU 530 by converting the power supplied from the power DC-DC unit 143.

The contactor controller 544 may operate with the voltage supplied from the power DC-DC unit 543, and may obtain information necessary for controlling the operation of the contactors 546, 547, and 548 and the Breaktor 549 by transmitting and receiving the information with the high voltage monitoring IC 540 through the SPI communication. The contact control unit 544 may control the operation of the contactors 546, 547, and 548 and the Breaktor 549 based on the control instruction from the MCU 141 and the information received from the high voltage monitoring IC 540.

The pyro fuse controller 545 may operate with the voltage supplied from the power DC-DC unit 543, and may obtain information needed to control the pyro fuse 551 by transmitting and receiving the information with the high voltage monitoring IC 540 through the SPI communication. The pyro fuse controller 545 may control the pyro fuse 551 based on the information received from the high voltage monitoring IC 540. If necessary, the pyro fuse controller 545 may receive the control instruction from the MCU 141 and consider the control instruction from the MCU 141 in controlling the pyro fuse 551.

Since the configuration of the sub-battery device 600 is the same as that of the sub-battery device 500, the detailed description thereof is omitted.

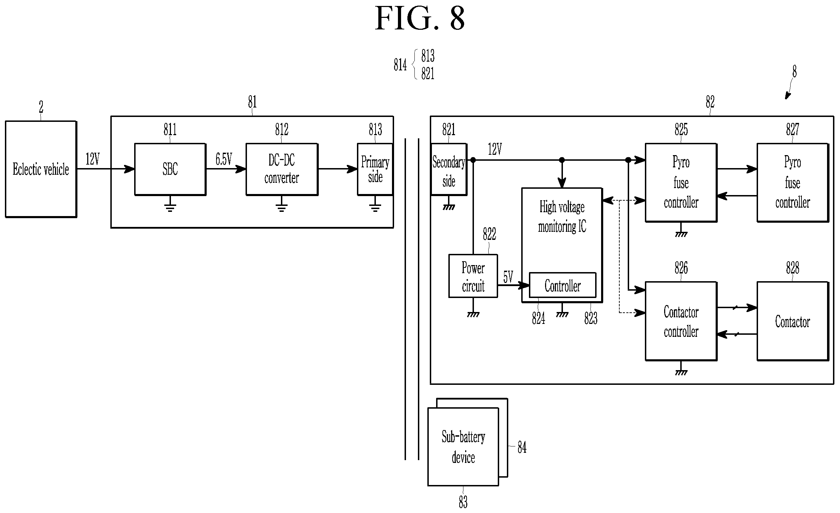

Hereinafter, power transferring of a plurality of battery devices in the battery system according to an embodiment is described with reference to FIG. 8 to FIG. 10.

FIG. 8 is a block diagram showing power transferring between a BPCM and a BDU according to an embodiment.

In FIG. 8, configurations related to the power transfer are mainly shown. As shown in FIG. 8, the main battery device includes a BPCM 81 and a BDU 82, and two sub-battery devices 83 and 84 receive the power from the BPCM 81. The voltage (for example, 12V) of an auxiliary power is supplied from the electric vehicle 10 to the BPCM 81. The electric vehicle 10 may be provided with the auxiliary power to supply the power to all equipment. FIG. 8 shows that the voltage is supplied from this auxiliary power supply to the BPCM 81, but the invention is not limited thereto. The BPCM 81 may receive a voltage supply from the battery pack.

The SBC 811 of the BPCM 81 converts the voltage of the auxiliary power supply and supplies it to the DC-DC converter 812. For example, the SBC 811 may change the voltage of 12 V of the auxiliary power supply to 6.5 V and supply it to the DC-DC converter 812. The DC-DC converter 812 may be implemented as a fly-back type. The DC-DC converter 812 may convert the input voltage to generate the output voltage, and the output voltage may be transferred to the BDU 82 through the transformer 814. Since a primary side 813 and a secondary side 821 of the transformer 814 are insulated, insulation power may be supplied from the BPCM 81 to the BDU 82. The primary coil constituting the transformer is provided on the primary side 813 of the transformer.

The BDU 82 includes the secondary side 821 of the transformer, and the secondary side 821 of the transformer is provided with a secondary side coil constituting the transformer. The output voltage of the DC-DC converter 812, which is insulation-transferred to the secondary side 821, may be supplied to the high voltage monitoring IC 823, the pyro fuse controller 825, and the contactor controller 826.

The power circuit 822 may convert the output voltage of the secondary side 821 to be supplied to the controller 824. For example, the output voltage of the secondary side 821 may be 12 V, and the power circuit 822 may convert the voltage of 12 V to a voltage of 5 V suitable for the controller 824 and supply it to the controller 824. The controller 824 may be a control circuit that controls the operation of the high voltage monitoring IC 823. In the preceding embodiment, the power DC-DC unit included in the BDU may include the secondary side 821 and the power circuit 822 shown in FIG. 8.

The high voltage monitoring IC 823, the pyro fuse controller 825, and the contactor controller 826 may be driven by the output voltage of the secondary side 821. A signal may be transmitted and received through SPI communication or a GPIO port (or an OC port) between the high voltage monitoring IC 823 and the pyro fuse controller 825, and between the high voltage monitoring IC 823 and the contactor controller 826. The pyro fuse controller 825 may control the action of disconnecting the pyro fuse 827. The contactor controller 826 may control the operations of the pre-charge contactor, the main positive/negative contactor, the DCFC contactor, and the like. The contactor 828 shown in FIG. 8 is a block for instructing a plurality of contactors, and a plurality of contactor control signals from the contactor controller 826 may be transferred in parallel to a plurality of contactors. In addition, the voltage or the current flowing generated to each of a plurality of contactors may be transferred to the contactor controller 826. The contactor controller 826 may detect a short circuit, an overcurrent, and a high temperature state by detecting a voltage and a current transferred from the contactor 828.

The high voltage monitoring IC 823 may transmit a control instruction to disconnect the pyro fuse 827 to the pyro fuse controller 825 when the overcurrent is detected. In addition, if the contactor 828 is not opened and remains in a closed state, the disconnection of the pyro fuse 827 may prevent a fire or a short circuit. In addition, when the impact detection signal from the electric vehicle 10 is transferred to the BPCM 81, the BPCM 81 may transmit a control instruction to disconnect the pyro fuse 827 to the pyro fuse controller 825 through the high voltage monitoring IC 823. At this time, the signal transmission and reception between the BPCM 81 and the BDU 82 may be implemented as the UART communication.

The high voltage monitoring IC 823 may transmit a control instruction for controlling the open and close of the contactor 828 to the contactor controller 826 through SPI communication. Alternatively, the high voltage monitoring IC 823 may transmit a signal for controlling the open or close of the contactor 828 to the contactor controller 826 by using the GPIO port. The contact controller 826 may detect a current flowing through the contactor 828 and transmit the information indicating the detected current to the high voltage monitoring IC 823 through the GPIO port. The contactor controller 826 may detect that the overcurrent flows in the contactor 828 or the high temperature is generated, and informs this to the high voltage monitoring IC 823 through the GPIO port.

The sub-battery devices 83 and 84 may also receive insulation power from the BPCM 81 and operate in the same way as the BDU 82.

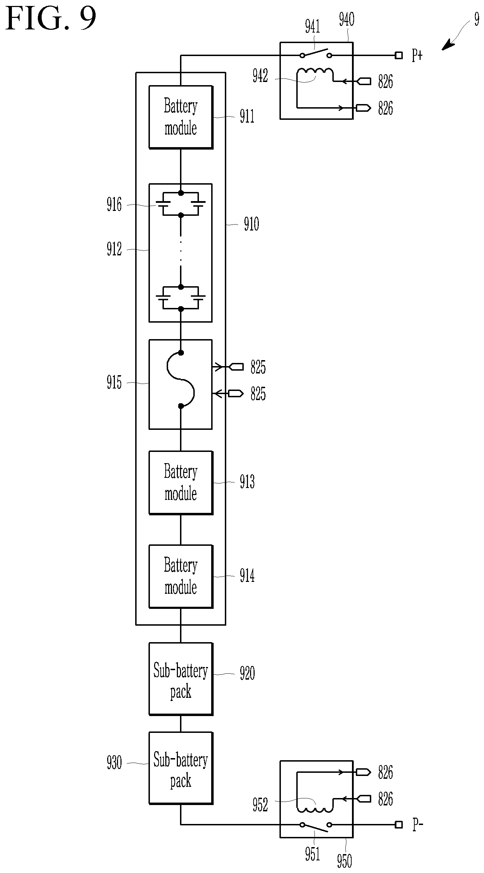

FIG. 9 is a view showing some configurations of a battery system according to an embodiment.

As shown in FIG. 9, a plurality of battery pack 910, 920, and 930 are connected in series. The main positive contactor 940 is connected between the positive electrode of the main battery pack 910 and the output terminal (P+) of the battery system 9, and the main negative contactor 950 is connected between the negative electrode of the sub-battery pack 930 and the output terminal (P-) of the battery system 9. The main battery pack 910 includes four battery modules 911 to 914 as an example, and the pyro fuse 915 is connected between the battery module 912 and the battery module 913. As an example, the battery module 912 may include a plurality of battery cells as a unit of two battery cells 916 connected in parallel. The sub-battery packs 920 and 930 may also have the same structure as the main battery pack 910. A contactor may be connected between the main battery pack 910 and the sub-battery pack 920 and between the sub-battery pack 920 and the sub-battery pack 930.

The main positive contactor 940 may include a switching unit 941 and a coil 942 driving the switching unit 941. The main negative electrode contactor 950 may include a switching unit 951 and a coil 952 that drives the switching unit 951. The main positive/negative contactors 940 and 950 may operate the switching units 941 and 951 when the current flows through the coils 942 and 952 by a signal supplied from the contactor controller 826, and in addition, both terminal voltages or the flowing current of each of the main positive/negative contactors 940 and 950 may be transferred to the contactor controller 826.

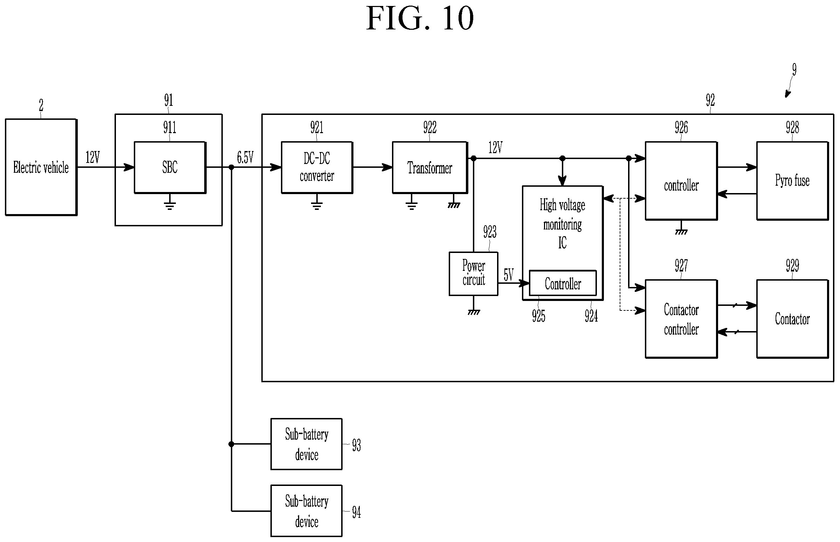

FIG. 10 is a block diagram showing power transferring between a BPCM and a BDU according to an embodiment.

In an embodiment shown in FIG. 10, a BPCM 91 and a BDU 92 are not insulated and a transformer 922 is positioned within the BDU 92, so the output voltage of the DC-DC converter 921 is converted by the transformer 922 to supply a power voltage to other components of the BDU 92. In the above embodiments, the power DC-DC unit of the BDU may include a DC-DC converter 921, a transformer 922, and a power circuit 923. The DC-DC converter 921 converts the power supplied from the BPCM 91 to generate an output voltage, and the output voltage of the DC-DC converter 921 is input to the transformer 922. The transformer 922 includes the primary side connected to the output terminal of the DC-DC converter 921 and the secondary side connected to each component of the BDU 92, and the voltage supplied to the primary side is transferred to the secondary side. That is, the transformer 922 may supply the output of the DC-DC converter 921 as the power voltage of each component of the BDU 92.

The power circuit 923, the high voltage monitoring IC 924, the controller 925, the pyro fuse controller 926, the contactor controller 927, the pyro fuse 928, and the contactor 929 are the same as the power circuit 822, the high voltage monitoring IC 823, the controller 825, the pyro fuse controller 825, the contactor controller 826, the pyro fuse 827, and the contactor 828 described with reference to FIG. 8 above so that the description thereof is omitted.

Like the BDU 92, the sub-battery devices 93 and 94 are also provided with the DC-DC converter and the transformer inside to convert the voltage supplied from the BPCM 81 to generate the power voltage.

When all low voltage/high voltage functions are processed in the BPCM (Battery Pack Control Module) within one battery pack, constraints such as battery pack complexity increasing are generated. The present invention may improve the complexity of the BPCM by providing the high voltage related functions in the BDU.

While this invention has been described in connection with what is presently considered to be practical embodiments, it is to be understood that the invention is not limited to the disclosed embodiments. On the contrary, it is intended to cover various modifications and equivalent arrangements included within the spirit and scope of the appended claims.

## Claims

1. A battery device comprising:
a battery pack including a plurality of battery cells;
a battery disconnect unit (BDU) including high voltage operation elements connected to the battery pack and monitoring a current of a battery pack current flowing in the battery pack; and
a battery pack control module (BPCM) diagnosing a state of the battery pack based on a battery state information indicating the state of the battery pack and transmitting necessary control instructions to the BDU based on the diagnosis result,
wherein the BDU includes:
a current measuring unit that measures the battery pack current based on a result of detecting the battery pack current;
a high voltage measuring unit that measures the battery pack voltage of the battery pack;
an insulation resistance measuring unit that measures insulation resistance of the battery pack; and
a power DC-DC unit that generates a power voltage required for the operation of the BDU.

2. The battery device of claim 1, wherein
the BDU further includes a shunt-type current sensor to detect the battery pack current.

3. The battery device of claim 2, wherein:
the BDU further includes a Hall-type current sensor to detect the battery pack current; and
the BPCM includes a current measuring unit that measures the battery pack current based on the result detected from the Hall-type current sensor.

4. The battery device of claim 1, wherein
the BDU further includes:
a main positive contactor and a main negative electrode contactor connected to the positive electrode and the negative electrode of the battery pack respectively; and
a contactor controller that controls the operation of the main positive contactor and the main negative electrode contactor.

5. The battery device of claim 1, wherein
the BDU further includes:
a pyro fuse that blocks connection between the battery pack and the load due to an impact; and
a pyro fuse controller to control the pyro fuse.

6. The battery device of claim 1, wherein
the BPCM includes a power DC-DC unit that supplies power in a form of insulation to the power DC-DC unit of the BDU.

7. The battery device of claim 1, further comprising:
a cell supervisory circuit CSC monitoring a plurality of cell voltages of the plurality of battery cells and temperatures of the plurality of battery cells and performing cell balancing

8. A battery system comprising:
a main battery device including a main battery pack; and
a sub-battery device that includes a sub-battery pack connected to the main battery pack,
wherein the main battery device includes:
a first battery disconnect unit (BDU) that includes high voltage operating elements connected to the main battery pack and monitors the current of the battery pack current flowing to the main battery pack; and
a battery pack control module (BPCM) that diagnoses a state of the main battery pack based on battery state information indicating the state of the main battery pack and transmits necessary control instructions to the BDU based on the diagnosis result, and
the first BDU includes:
a current measuring unit that measures the battery pack current based on a result of detecting the battery pack current;
a first high voltage measuring unit that measures the battery pack voltage of the main battery pack;
a first insulation resistance measuring unit that measures insulation resistance of the main battery pack; and
a first power DC-DC unit that generates power voltage required for the operation of the first BDU.

9. The battery system of claim 8, wherein
the BPCM further includes a power DC-DC unit that supplies power in a form of insulation to the first power DC-DC unit.

10. The battery system of claim 8, wherein
the sub-battery device includes
a second BDU including high voltage operating elements connected to the sub-battery pack,
the second BDU includes
a second high voltage measuring unit that measures the battery pack voltage of the sub-battery pack,
a second insulation resistance measuring unit that measures the insulation resistance of the sub-battery pack, and
a second power DC-DC unit that generates a power voltage required for operation of the second BDU, and
the BPCM includes a power DC-DC unit that supplies power in a form of insulation to the second power DC-DC unit.

11. The battery system of claim 8, wherein
the first BDU further includes:
a main positive contactor and a main negative electrode contactor connected to the positive electrode and the negative electrode of the main battery pack respectively; and
a contactor controller that controls the operation of the main positive contactor and the main negative electrode contactor.

12. The battery system of claim 11, wherein
insulation power is transferred from the BPCM to the first power DC-DC unit, and
the first power DC-DC unit supplies a power voltage to the current measuring unit, the first high voltage measuring unit, the first insulation resistance measuring unit, and the contactor controller as the insulation power.

13. The battery system of claim 11, wherein
power is transferred from the BPCM to the first power DC-DC unit,
the first power DC-DC unit includes
a DC-DC converter that converts the transferred power, and
a transformer connected to the output of the DC-DC converter, and
a power voltage is supplied from the transformer to the current measuring unit, the first high voltage measuring unit, the first insulation resistance measuring unit, and the contactor controller.

14. The battery system of claim 8, wherein
the first BDU further includes:
a pyro fuse that blocks the connection between the main battery pack and the load due to an impact; and
a pyro fuse controller to control the pyro fuse.

15. The battery system of claim 14, wherein
insulation power is transferred from the BPCM to the first power DC-DC unit, and
the first power DC-DC unit supplies a power voltage to the current measuring unit, the first high voltage measuring unit, the first insulation resistance measuring unit, and the pyro fuse controller. as the insulation power.

16. The battery system of claim 14, wherein
power is transferred from the BPCM to the first power DC-DC unit, and
the first power DC-DC unit includes
a DC-DC converter that converts the transferred power, and
a transformer connected to the output of the DC-DC converter, and
a power voltage is supplied to the current measuring unit, the first high voltage measuring unit, the first insulation resistance measuring unit, and the pyro fuse controller from the transformer.
